# EUROPÄISCHE PATENTSCHRIFT

(11) **EP 2 137 649 B1**
(45) Veröffentlichungstag und Bekanntmachung des Hinweises auf die Patenterteilung: **25.01.2017**
(21) Anmeldenummer: 08716129.5
(22) Anmeldetag: 29.02.2008
(51) Int. Cl.: G06F 17/50

(54) **AUTOMATISCHES ERZEUGEN EINER VERNETZUNG EINES KOMPONENTENMODELLS**
AUTOMATIC MESH GENERATION METHOD FOR A COMPONENT MODEL
PRODUCTION AUTOMATIQUE D'UNE MISE EN RÉSEAU D'UN MODÈLE DE COMPOSANT

(30) Priorität: 16.03.2007 DE 102007012633
(43) Veröffentlichungstag der Anmeldung: 30.12.2009
(73) Patentinhaber: Bayerische Motoren Werke Aktiengesellschaft, 80809 München (DE)
(72) Erfinder: GUIST, Christian, 85570 Markt Schwaben (DE)
(74) Vertreter: Mayer-Martin, Christian
(86) Internationale Anmeldenummer: PCT/EP2008/001605
(87) Internationale Veröffentlichungsnummer: WO 2008/113463

(56) Entgegenhaltungen:
- BERCIN A N: "Eigenfrequencies of rectangular plate assemblies" COMPUTERS AND STRUCTURES ELSEVIER UK, Bd. 65, Nr. 5, 1997, Seiten 703-711, XP002487650 ISSN: 0045-7949
- NEUMANN J ET AL: "Computation of Single Eigenfrequencies and Eigenfunctions of Plate and Shell Structures Using an H-adaptive FE-method" COMPUTATIONAL MECHANICS ; SOLIDS, FLUIDS, ENGINEERED MATERIALS, AGING INFRASTRUCTURE, MOLECULAR DYNAMICS, HEAT TRANSFER, MANUFACTURING PROCESSES, OPTIMIZATION, FRACTURE & INTEGRITY, SPRINGER-VERLAG, BE, Bd. 40, Nr. 1, 21. Juni 2006 (2006-06-21), Seiten 111-126, XP019518280 ISSN: 1432-0924
- WIBERG N -E ET AL: "Improved eigenfrequencies and eigenmodes in free vibration analysis" COMPUTERS AND STRUCTURES ELSEVIER UK, Bd. 73, Nr. 1-5, 1999, Seiten 79-89, XP002487651 ISSN: 0045-7949

## Beschreibung

Die Erfindung betrifft ein Verfahren und eine Einrichtung zum automatischen Erzeugen einer Vernetzung eines Komponentenmodells basierend auf finiten Elementen und ein entsprechendes Computerprogrammprodukt.

Die Finite-Elemente-Methode (FEM) ist ein weit verbreitetes Berechnungsverfahren im Ingenieurwesen. Bei der Finite-Elemente-Methode wird ein Berechnungsgebiet in eine große Zahl kleiner, aber endlich vieler Elemente unterteilt. Auf diesen Elementen werden in der Regel Ansatzfunktionen definiert, aus denen sich über eine partielle Differentialgleichung und die Randbedingungen ein großes Gleichungssystem ergibt. Aus dem gelösten Gleichungssystem werden danach die gesuchten Resultate abgeleitet.

Aus der DE 10360150 A1 ist es bekannt, basierend auf einer vorgegebenen Vernetzung eines Konstruktionsmodells die Einhüllende eines Körpers zu bestimmen, um physikalische Vorgänge an der Oberfläche eines technischen Systems durch eine Finite-Elemente-Simulation nachzubilden.

Aus der DE 10326228 A1 ist es bekannt, die Vernetzung für Finite-Elemente-Simulationen eines Systems mit mehreren Körpern zu beschleunigen.

Aus der US 6044210 ist es bekannt, ein Finite-Elemente-Modell für ein Strukturelement zu bestimmen.

Aus dem Artikel "Eigenfrequenzies of Rectangular Plate Assemblies", Computer & Structures Vol. 65, No. 5, pp.703-711, 1997 ist bekannt, die ersten 10 Eigenmoden eines Komponentenmodells mit finiten Elementen zu berechnen. Der Oberbegriff der unabhängigen Ansprüche beruht auf dieser Druckschrift.

Mit einer Standardsoftware für Finite-Elemente-Simulationen, wie ABAQUS, ist es bereits möglich ein Komponentenmodell automatisch zu vernetzen, d.h. durch eine Vielzahl finiter Elemente zu beschreiben. Insbesondere ist es mit dieser Standardsoftware schon möglich, FE (Finite-Elemente)-Netze an einen Anwendungsfall anzupassen. Zum Beispiel sieht ABAQUS ein sog.

"Adaptive Remeshing"vor, bei dem zunächst ein Komponentenmodell durch ein grobes FE-Netz (gleichbedeutend mit "grobe Vernetzung finiter Elemente" oder "grobe Vernetzung mit finiten Elementen") beschrieben wird, und dieses in einem Bereich, in dem hohe mechanische Spannungen auftreten, automatisch verfeinert wird, um das Komponentenmodell für weitere Berechnungen geeigneter zu beschreiben. Das automatische Durchführen der Verfeinerung wird in Abhängigkeit von den Spannungsgradienten zwischen zwei FE-Elementen ausgelöst. Bei dem Verfahren wird der Spannungsgradient zwischen den FE-Elementen bestimmt. Liegt dieser über einem bestimmten Wert, wird das Netz an dieser Stelle verfeinert. Durch die feinere Auflösung sinkt der Spannungsgradient. Diese Prozedur wird solange iterativ durchgeführt, bis die Spannungsgradienten den festgelegten Kriterien entsprechen. Je feiner die Vernetzung, desto besser kann die Vernetzung in der Regel das Komponentenmodell beschreiben, desto mehr Speicherplatz erfordert es in der Regel, und desto rechenintensiver sind in der Regel weitere Berechnungen oder Simulationen, die auf dieser Vernetzung basieren.

Der Erfindung liegt nun die Aufgabe zu Grunde, eine technische Lehre zum automatischen Erzeugen einer Vernetzung eines Komponentenmodells anzugeben, die wenig Speicherplatz erfordert und das Komponentenmodell dennoch geeignet oder realitätsnah beschreibt.

Diese Aufgabe wird durch die Merkmale der unabhängigen Ansprüche gelöst. Vorteilhafte Weiterbildungen der Erfindung sind den abhängigen Ansprüchen zu entnehmen. Im Rahmen der Erfindung liegen auch Weiterbildungen des Einrichtungsanspruchs und des Computerprogrammproduktanspruchs, die den abhängigen Verfahrensansprüchen entsprechen.

Die Erfindung basiert demnach zunächst auf dem Gedanken, nicht wie im Stand der Technik von einer groben Vernetzung nach und nach zu einer feineren Vernetzung überzugehen, sondern gerade umgekehrt ein Komponentenmodell zunächst durch eine feine Vernetzung zu beschreiben, und ausgehend von dieser feinen Vernetzung, insbesondere nach und nach, zumindest bereichsweise zu einer gröberen Vernetzung überzugehen.

Dies hat den Vorteil, dass eine Entscheidung darüber, welcher Bereich eines Komponentemodells fein zu vernetzen ist, und welcher Bereich grob zu vernetzen ist, auf einer feinen Vernetzung basiert und somit zuverlässiger oder zielführender ist als im Stand der Technik. Dies führt zu einer geeigneteren Vernetzung eines Komponentenmodells als im Stand der Technik, die aber insbesondere aufgrund gezielt ausgewählter Bereiche grober Vernetzung ebenfalls mit wenig Speicherplatz auskommt. Ein weiterer Vorteil liegt darin, dass eine automatische Vernetzung dann besonders gut möglich ist, wenn die Elementgröße klein ist.

Die Erfindung basiert auf dem weiteren Gedanken, gezielt - für eine Beschreibung durch eine gröbere Vernetzung - geeignete Bereiche des Komponentenmodells zu ermitteln, indem das Deformationsverhalten der finiten Elemente untersucht wird.

Vorzugsweise ist zum automatischen Erzeugen einer Vernetzung eines vorgegebenen, beispielsweise durch CAD-Daten beschriebenen, Komponentenmodells vorgesehen, dass das Komponentenmodell insbesondere automatisch durch eine feine Vernetzung finiter Elemente (oder mit finiten Elementen) beschrieben wird.

Insbesondere automatisch wird basierend auf der feinen Vernetzung das Eigenschwingverhalten des Komponentenmodells, insbesondere in einem vorgegebenen Frequenzbereich, von beispielsweise 100 Herz bis 3000 Herz, bestimmt, und basierend auf dem Eigenschwingverhalten insbesondere automatisch zumindest ein Bereich des Komponentenmodells bestimmt, dessen finite Elemente weniger oder schwächer deformiert werden (insbesondere ist den finiten Elementen rechnerisch eine schwächere Deformation zugeordnet) als die finiten Elemente eines anderen Bereichs des Komponentenmodells. Insbesondere automatisch wird dieser Bereich dann insbesondere bevorzugt durch eine gröbere Vernetzung finiter Elemente beschrieben als zuvor und/oder als der andere Bereich des Komponentenmodells.

Dadurch wird erreicht dass basierend auf einer feinen Vernetzung zuverlässig und genau das Eigenschwingverhalten des Komponentenmodells und/oder das Deformationsverhalten der finiten Elemente des Komponentenmodells bestimmt werden kann, und basierend auf diesem genauen und zuverlässigen Ergebnis gezielt und genau die Bereiche durch eine gröbere Vernetzung beschrieben werden können, die weniger deformiert werden. Die gezielte gröbere Vernetzung dieser Bereiche hat einen geringeren negativen Einfluss auf die Güte, Geeignetheit oder Qualität der gesamten Vernetzung des Komponentenmodells als die gröbere Vernetzung der Bereiche, in denen die finiten Elemente stark deformiert werden, oder als die willkürliche gröbere Vernetzung des Komponentenmodells.

Dadurch kann die Vernetzung das Komponentenmodell speichereffizient dargestellt werden und effizient weiterverarbeitet werden, und dennoch so geeignet beschrieben werden, dass auf der Vernetzung des Komponentenmodells basierende Simulationen zu ausreichend genauen Ergebnissen führen.

Das Komponentenmodell kann dabei ein insbesondere rechnerverfügbares Konstruktionsmodell eines beliebigen technischen Systems oder einer beliebigen technischen Struktur, wie eines Motors oder eines Motorelementes oder eines Teils eines Motorelementes sein.

Bei der groben oder gröberen Vernetzung des Komponentenmodells ist beispielsweise das durchschnittliche Volumen oder die durchschnittliche Kantenlänge der zur Vernetzung verwendeten finiten Elemente zumindest in einem Bereich des Komponentenmodells oder im gesamten Komponentenmodell größer als bei der feinen Vernetzung.

Die automatische Beschreibung des Komponentenmodells durch eine feine bzw. grobe oder gröbere Vernetzung an sich ist beispielsweise aus der Standardsoftware ABAQUS bekannt und damit durchführbar. Dies gilt auch für die Bestimmung einer Eigenfrequenz oder einer Eigenschwingform einer Eigenschwingung basierend auf einer zuvor automatisch erzeugten Vernetzung an sich.

Die Bestimmung der Deformation von finiten Elementen an sich ist beispielsweise aus der Standardsoftware ABAQUS bekannt. Beispielsweise wird ein finites Element dann stärker deformiert als ein anderes, wenn sich die Abstände der Knoten, die zu diesem finiten Element gehören, aufgrund der Berechnung stärker ändern als die Abstände des anderen finiten Elementes, oder wenn die Differenz zwischen maximalem Volumen und minimalem Volumen während der Periode der längsten Eigenschwingung größer ist als die entsprechende Differenz des anderen finiten Elementes.

Alternativ oder ergänzend zur Deformation der finiten Elemente kann auch eine mit der Deformation korrelierende Größe als Kriterium für eine durchzuführende Vergröberung der Vernetzung heran gezogen werden. Beispielsweise kann basierend auf dem Eigenschwingverhalten zumindest ein Bereich des Komponentenmodells bestimmt und durch eine gröbere Vernetzung beschrieben werden, in dem den zugehörigen finiten Elementen insbesondere rechnerisch eine geringere Dehnung, eine geringere Spannung, ein geringerer Dehnungsgradient, ein geringerer Spannungsgradient, eine geringere Kantenlängenänderung, eine geringere Knotenverschiebung oder eine geringere Volumenänderung zugeordnet ist, als finiten Elemente in einem anderen Bereich.

Eine bevorzugte Weiterbildung der Erfindung sieht vor, dass basierend auf der feinen Vernetzung insbesondere automatisch zumindest eine Fein-Eigenschwingung (eine bestimmte auf der feinen Vernetzung basierende Eigenschwingung des Komponentenmodells), insbesondere eine Fein-Eigenfrequenz (auf der feinen Vernetzung basierende Eigenfrequenz des Komponentenmodells einer bestimmten Eigenschwingung) und/oder eine Fein-Eigenschwingform (auf der feinen Vernetzung basierende Eigenschwingform des Komponentenmodells einer bestimmten Eigenschwingung), des Komponentenmodells bestimmt wird. Dann wird das Komponentenmodell insbesondere automatisch zumindest bereichsweise durch eine grobe Vernetzung finiter Elemente beschrieben, und basierend auf der groben Vernetzung zumindest eine Grob-Eigenschwingung (eine bestimmte auf der groben Vernetzung basierende Eigenschwingung des Komponentenmodells), insbesondere eine Grob-Eigenfrequenz (auf der groben Vernetzung basierende Eigenfrequenz des Komponentenmodells einer bestimmten Eigenschwingung) und/oder eine Grob-Eigenschwingform (auf der groben Vernetzung basierende Eigenschwingform des Komponentenmodells einer bestimmten Eigenschwingung), des Komponentenmodells bestimmt. Die Abweichung der Grob-Eigenfrequenz von der Fein-Eigenfrequenz und/oder die Abweichung der Grob-Eigenschwingform von der Fein-Eigenschwingform werden dann insbesondere automatisch als Maß für die Güte, Qualität oder Geeignetheit der groben Vernetzung verwendet und beispielsweise angezeigt.

Es wird also das Komponentenmodell zunächst durch die feine Vernetzung geeignet aber speicherintensiv beschrieben, und damit insbesondere die darauf basierende Fein-Eigenfrequenz genau bestimmt. Dann wird das Komponentenmodell zumindest bereichsweise durch eine grobe Vernetzung mit weniger Speicherbedarf beschrieben, und insbesondere die darauf basierende Grob-Eigenfrequenz genau bestimmt. Ob diese grobe Vernetzung das Komponentenmodell noch geeignet beschreibt, kann dann aufgrund der Abweichung der Grob-Eigenfrequenz von der Fein-Eigenfrequenz bestimmt werden. Je kleiner die Abweichung, desto geeigneter oder realistischer ist die Beschreibung des Komponentenmodells basierend auf der groben Vernetzung.

Im Rahmen der Erfindung liegt es selbstverständlich auch, basierend auf verschiedenen Vernetzungen jeweils mehrere Eigenschwingungen, insbesondere Eigenfrequenzen, zu bestimmen und entsprechende Abweichungen als Gütekriterium zu verwenden.

Besonders bevorzugt ist vorgesehen, ausgehend von einer feinen Vernetzung das Komponentenmodell insbesondere automatisch nach und nach, insbesondere bereichsweise, durch zunehmend gröbere Vernetzungen zu beschreiben, insbesondere solange bis die Abweichung der Grob-Eigenfrequenz von der Fein-Eigenfrequenz einen vorgegebenen oder durch einen Anwender eingestellten Schwellwert überschreitet.

Die Abweichung der Grob-Eigenfrequenz von der Fein-Eigenfrequenz kann dann insbesondere automatisch als Abbruch-Kriterium einer automatisierten Vernetzung eines Komponentenmodells verwendet werden, bei dem ausgehend von einer feinen Vernetzung das Komponentenmodell nach und nach automatisch durch eine zumindest in bestimmten Bereichen zunehmend gröbere Vernetzung beschrieben wird.

Vorzugsweise wird zudem zunächst basierend auf der feinen Vernetzung das Eigenschwingverhalten des Komponentenmodells, insbesondere in einem vorgegebenen Frequenzbereich, bestimmt, basierend auf dem Eigenschwingverhalten zumindest ein Bereich des Komponentenmodells bestimmt, dessen finite Elemente stärker deformiert werden als die finiten Elemente eines anderen Bereichs des Komponentenmodells, und dieser Bereich des Komponentenmodells durch eine noch feinere Vernetzung finiter Elemente oder eine noch feinere Vernetzung mit finiten Elemente beschrieben.

Das Eigenschwingverhalten des Komponentenmodells basiert vorzugsweise auf einer Überlagerung mehrerer (zwei bis alle) in einem vorgegebenen Frequenzbereich liegender Eigenschwingungen. Insbesondere wird also das Deformationsverhalten der finiten Elemente für den Fall betrachtet, dass das Komponentenmodell mit einer Überlagerung mehrerer oder aller in einem vorgegebenen Frequenzbereich liegender Eigenschwingungen schwingt.

Im Rahmen der Erfindung liegt auch eine Einrichtung zum automatischen Erzeugen einer Vernetzung eines Komponentenmodells mit einer Recheneinrichtung, die derart eingerichtet ist, dass ein beschriebenes Verfahren durchgeführt wird.

Im Rahmen der Erfindung liegt auch ein Computerprogrammprodukt zum automatischen Erzeugen einer Vernetzung eines Komponentenmodells, das ein computerlesbares Speichermedium umfasst, auf dem ein Programm gespeichert ist, welches es einer Datenverarbeitungsanlage ermöglicht, nachdem es in einen Speicher einer Datenverarbeitungsanlage geladen worden ist, dass ein beschriebenes Verfahren durchgeführt wird.

Im Folgenden wird die Erfindung anhand eines Beispiels näher erläutert.

Es wird ein neues Verfahren vorgeschlagen, das auf die Akustikberechnung abgestimmt ist. Die Akustikberechnung benötigt FE-Modelle, welche das Eigenschwingverhalten des modellierten Bauteils gut wiedergibt. Dies soll mit möglichst großen Elementgrößen erreicht werden. Der Nachteil der geringen Elementgrößen ist die Vielzahl der Elemente und der damit verbundene hohe Speicherplatz der Modelle sowie die langen Rechenzeiten. Für die Akustikberechnung werden üblicherweise komplette Motor-Getriebe-Verbände aufgebaut, die aus sehr vielen Bauteilen bestehen.

Bei dem vorgeschlagenen Verfahren wird von einem feinen FE-Netz (feine Vernetzung) ausgegangen. Dies dient dazu das Eigenschwingverhalten möglichst gut abzubilden. Dieses FE-Netz dient als Basis und Referenz für die weiteren Berechnungen. Für dieses Modell (beschrieben durch die feine Vernetzung) wird das Eigenschwingverhalten in einem vorgegebenen Frequenzbereich berechnet.

Jede der in diesem Bereich auftretenden Schwingmoden erzeugt eine zyklisch veränderliche Deformation im FE-Modell (= FE-Netz). Dabei entstehen in bestimmten Bereichen große Dehnungen, andere Bereiche weisen nur geringe Dehnungen auf. In den Bereichen mit der hohen Dehnung ist es wichtig, dass die Steifigkeit richtig abgebildet ist. Dies wird durch die Verwendung feiner FE-Elemente (geringe Elementgrößen, feine Vernetzung) erreicht.

Die Bereiche geringer Dehnungen können gröber modelliert werden. Soll das Modell für einen Frequenzbereich gute Ergebnisse liefern, wird vorgeschlagen, die Deformation aller Moden, die in diesem Frequenzbereich vorkommen, zu überlagern. Anschließend wird das nachfolgend beschriebene Verfahren auf das Modell mit der entsprechenden Gesamtdeformation angewendet.

Das vorgeschlagene Verfahren soll die FE-Elementgröße der Dehnung anpassen. Das Prinzip dabei ist es, in Bereichen hoher Dehnung ein feines Netz beizubehalten (oder noch zu verfeinern) und in Bereichen geringer Dehnung das FE-Netz (Vernetzung) zu vergröbern. Der formelmäßige Zusammenhang zwischen Dehnung und FE-Elementgröße ist durch den Anwender wählbar.

Mit dem so modifizierten Netz wird eine neue Berechnung durchgeführt. Die Ergebnisse werden mit der vorhergehenden Berechung hinsichtlich Eigenfrequenz und Eigenmode (z.B. geprüft an Auslenkungen von ausgewählten Punkten) verglichen. Liegt die Abweichung des vergröberten Netzes unterhalb einer vorzugebenden Grenze, kann nach der oben genannten Methode weiter vergröbert werden, ansonsten wird das Verfahren abgebrochen und die letzte gültige Berechnung verwendet.

## Patentansprüche

1. Verfahren zum rechnergestützten automatischen Erzeugen einer Vernetzung eines Komponentenmodells,
- bei dem das Komponentenmodell durch eine feine Vernetzung finiter Elemente beschrieben wird,
- bei dem basierend auf der feinen Vernetzung das Eigenschwingverhalten des Komponentenmodells bestimmt wird, indem basierend auf der feinen Vernetzung zumindest eine Fein-Eigenschwingung, insbesondere eine Fein-Eigenfrequenz und/oder eine Fein-Eigenschwingform, des Komponentenmodells bestimmt wird,
**dadurch gekennzeichnet dass**
- basierend auf dem Eigenschwingverhalten zumindest ein Bereich des Komponentenmodells bestimmt wird, dessen finite Elemente weniger deformiert werden als die finiten Elemente eines anderen Bereichs des Komponentenmodells, und
- dieser Bereich des Komponentenmodells durch eine gröbere Vernetzung finiter Elemente beschrieben wird.

2. Verfahren nach Anspruch 1,
- bei dem basierend auf der feinen Vernetzung zumindest eine Fein-Eigenschwingung, insbesondere eine Fein-Eigenfrequenz und/oder eine Fein-Eigenschwingform, des Komponentenmodells bestimmt wird,
- bei dem das Komponentenmodell durch eine grobe Vernetzung finiter Elemente beschrieben wird,
- bei dem basierend auf der groben Vernetzung zumindest eine Grob-Eigenschwingung, insbesondere eine Grob-Eigenfrequenz und/oder eine Grob-Eigenschwingform, des Komponentenmodells bestimmt wird, und
- bei dem die Abweichung der Grob-Eigenschwingung, insbesondere der Grob-Eigenfrequenz und/oder der Grob-Eigenschwingform, von der Fein-Eigenschwingung, insbesondere der Fein-Eigenfrequenz und/oder der Fein-Eigenschwingform, als Maß für die Güte der groben Vernetzung verwendet wird.

3. Verfahren nach einem der vorhergehenden Ansprüche,
bei dem ausgehend von einer feinen Vernetzung das Komponentenmodell nach und nach durch zunehmend gröbere Vernetzungen beschrieben wird, insbesondere solange bis die Abweichung der Grob-Eigenschwingung, insbesondere der Grob-Eigenfrequenz und/oder der Grob-Eigenschwingform, von der Fein-Eigenschwingung, insbesondere der Fein-Eigenfrequenz und/oder der Fein-Eigenschwingform, einen Schwellwert überschreitet.

4. Verfahren nach einem der vorhergehenden Ansprüche,
bei dem basierend auf der feinen Vernetzung das Eigenschwingverhalten des Komponentenmodells bestimmt wird,
bei dem basierend auf dem Eigenschwingverhalten zumindest ein Bereich des Komponentenmodells bestimmt wird, dessen finite Elemente stärker deformiert werden als die finiten Elemente eines anderen Bereichs des Komponentenmodells, und
bei dem dieser Bereich des Komponentenmodells durch eine feinere Vernetzung finiter Elemente beschrieben wird.

5. Verfahren nach einem der vorhergehenden Ansprüche,
bei dem das Eigenschwingverhalten auf einer Überlagerung mehrerer in einem vorgegebenen Frequenzbereich liegender Eigenschwingungen basiert.

6. Einrichtung zum automatischen Erzeugen einer Vernetzung eines Komponentenmodells
mit einer Recheneinrichtung, die derart eingerichtet ist,
- dass das Komponentenmodell durch eine feine Vernetzung finiter Elemente beschrieben wird,
- dass basierend auf der feinen Vernetzung das Eigenschwingverhalten des Komponentenmodells bestimmt wird,
**dadurch gekennzeichnet,**
- **dass** basierend auf dem Eigenschwingverhalten zumindest ein Bereich des Komponentenmodells bestimmt wird, dessen finite Elemente weniger deformiert werden als die finiten Elemente eines anderen Bereichs des Komponentenmodells, und
- **dass** dieser Bereich des Komponentenmodells durch eine gröbere Vernetzung finiter Elemente beschrieben wird.

7. Computerprogrammprodukt zum automatischen Erzeugen einer Vernetzung eines Komponentenmodells,
das ein computerlesbares Speichermedium umfasst, auf dem ein Programm gespeichert ist, welches es einer Datenverarbeitungsanlage ermöglicht, nachdem es in einen Speicher einer Datenverarbeitungsanlage geladen worden ist,
- dass das Komponentenmodell durch eine feine Vernetzung finiter Elemente beschrieben wird,
- dass basierend auf der feinen Vernetzung das Eigenschwingverhalten des Komponentenmodells bestimmt wird,
**dadurch gekennzeichnet,**
- **dass** basierend auf dem Eigenschwingverhalten zumindest ein Bereich des Komponentenmodells bestimmt wird, dessen finite Elemente weniger deformiert werden als die finiten Elemente eines anderen Bereichs des Komponentenmodells, und
- **dass** dieser Bereich des Komponentenmodells durch eine gröbere Vernetzung finiter Elemente beschrieben wird.

## Claims

1. A method for the computer-aided automatic generation of a mesh of a component model,
- wherein the component model is described by a fine mesh of finite elements,
- wherein based on the fine mesh, the natural oscillation behaviour of the component model is determined, in that based on the fine mesh, at least one fine natural oscillation, more especially a fine natural frequency and/or a fine natural oscillation mode, of the component model is determined,
**characterised in that**
- based on the natural oscillation behaviour, at least one region of the component model is determined, the finite elements of which are less deformed than the finite elements of another region of the component model, and
- this region of the component model is described by a coarser mesh of finite elements.

2. A method according to claim 1,
- wherein based on the fine mesh, at least one fine natural oscillation, more especially a fine natural frequency and/or a fine natural oscillation mode, of the component model is determined,
- wherein the component model is described by a coarse mesh of finite elements,
- wherein based on the coarse mesh, at least one coarse natural oscillation, more especially a coarse natural frequency and/or a coarse natural oscillation mode, of the component model is determined, and
- wherein the deviation of the coarse natural oscillation, more especially of the coarse natural frequency and/or of the coarse natural oscillation mode, from the fine natural oscillation, more especially from the fine natural frequency and/or from the fine natural oscillation mode, is used as an indication of the quality of the coarse mesh.

3. A method according to either one of the preceding claims, wherein starting from a fine mesh, the component model is gradually described by increasingly coarser meshes, more especially until the deviation of the coarse natural oscillation, more especially of the coarse natural frequency and/or of the coarse natural oscillation mode, from the fine natural oscillation, more especially from the fine natural frequency and/or from the fine natural oscillation mode exceeds a threshold value.

4. A method according to any one of the preceding claims, wherein based on the fine mesh, the natural oscillation behaviour of the component model is determined, wherein based on the natural oscillation behaviour, at least one region of the component model is described, the finite elements of which are more greatly deformed than the finite elements of another region of the component model, and wherein this region of the component model is described by a finer mesh of finite elements.

5. A method according to any one of the preceding claims, wherein the natural oscillation behaviour is based on an overlapping of a plurality of natural oscillations which lie within a predetermined frequency range.

6. A system for automatically generating a mesh of a component model, with a computer which is configured such that
- the component model is described by a fine mesh of finite elements,
- based on the fine mesh, the natural oscillation behaviour of the component model is determined,
**characterised in that**
- based on the natural oscillation behaviour, at least one region of the component model is determined, the finite elements of which are less deformed than the finite elements of another region of the component model, and
- this region of the component model is described by a coarser mesh of finite elements.

7. A computer program product for automatically generating a mesh of a component model, which product comprises a computer-readable storage medium, on which a program is stored which enables a data processing system, after said program has been loaded into a memory of a data processing system, such that
- the component model is described by a fine mesh of finite elements,
- based on the fine mesh, the natural oscillation behaviour of the component model is determined,
**characterised in that**
- based on the natural oscillation behaviour, at least one region of the component model is determined, the finite elements of which are less deformed than the finite elements of another region of the component model, and
- this region of the component model is described by a coarser mesh of finite elements.

## Revendications

1. Procédé d'obtention automatique assistée par ordinateur d'une mise en réseau d'un modèle de composants selon lequel :
le modèle de composants est décrit par une mise en réseau fine d'éléments finis,
sur le fondement de la mise en réseau fine, le comportement d'oscillation propres du modèle de composants est déterminé en déterminant sur le fondement de la mise en réseau fine au moins une oscillation propre fine, en particulier une fréquence propre fine et/ou un mode d'oscillation propre fin du modèle de composants,
**caractérisé en ce que**
sur le fondement du comportement d'oscillation propre on détermine au moins une zone du modèle de composants dont les éléments finis sont moins déformés que les éléments finis d'une autre zone du modèle de composants, et
cette zone du modèle de composant est décrite par une mise en réseau grossière d'éléments finis.

2. Procédé conforme à la revendication 1,
selon lequel
sur le fondement de la mise en réseau fine, au moins une oscillation propre fine, en particulier une fréquence propre, fine et/ou un mode d'oscillation propre fin du modèle de composants est déterminé,
le modèle de composants est décrit par une mise en réseau grossière d'éléments finis,
sur le fondement de la mise en réseau grossière, au moins une oscillation propre grossière, en particulier une fréquence propre grossière et/ou un mode d'oscillation propre grossier du modèle de composants est déterminé, et
l'écart entre l'oscillation propre grossière, en particulier la fréquence propre grossière et/ou le mode d'oscillation propre grossier par rapport à l'oscillation propre fine, en particulier la fréquence propre fine et/ou le mode d'oscillation propre fin est utilisé en tant que mesure de la qualité de la mise en réseau grossière.

3. Procédé conforme à l'une des revendications précédentes,
selon lequel, à partir d'une mise en réseau fine, le modèle de composants est progressivement décrit par des mises en réseau devenant de plus en plus grossières, en particulier jusqu'à ce que l'écart entre l'oscillation propre grossière, en particulier la fréquence propre grossière et/ou le mode d'oscillation propre grossier et l'oscillation propre fine, en particulier la fréquence propre fine et/ou le mode d'oscillation propre fin dépasse une valeur de seuil.

4. Procédé conforme à l'une des revendications précédentes,
selon lequel, sur le fondement de la mise en réseau fine on détermine le comportement d'oscillation propre du modèle de composant,
sur le fondement du comportement d'oscillation propre, on détermine au moins une zone du modèle de composants dont les éléments finis sont déformés plus fortement que les éléments finis d'une autre zone du modèle de composants, et
cette zone du modèle de composants est décrite par une mise en réseau plus fine d'éléments finis.

5. Procédé conforme à l'une des revendications précédentes,
selon lequel, le comportement d'oscillation propre est basé sur une superposition de plusieurs oscillations propres situées dans une plage de fréquences prédéfinie.

6. Dispositif d'obtention automatique d'une mise en réseau d'un modèle de composants comprenant un dispositif de calcul qui est conçu de façon telle que
- le modèle de composants soit décrit par une mise en réseau fine d'éléments finis,
- le comportement d'oscillation propre du modèle de composant soit déterminé sur le fondement de la mise en réseau fine,
**caractérisé en ce que**
sur le fondement du comportement d'oscillation propre on détermine au moins une zone du modèle de composants dont les éléments finis sont moins déformés que les éléments finis d'une autre zone du modèle de composants, et
cette zone du modèle de composants est décrite par une mise en réseau plus grossière d'éléments finis.

7. Produit programme d'ordinateur permettant l'obtention automatique d'une mise en réseau d'un modèle de composants,
qui comprend un support de mémoire lisible par ordinateur sur lequel est enregistré un programme qui permet à une installation de traitement de données, après qu'il ait été chargé dans la mémoire de cette installation de traitement de données,
de décrire le modèle de composants par une mise en réseau fine d'éléments finis,
de déterminer le comportement d'oscillation propres du modèle de composants sur le fondement de la mise en réseau fine,
**caractérisé en ce que**
sur le fondement du comportement d'oscillations propre on détermine au moins une zone du modèle de composants dont les éléments finis sont moins déformés que les éléments finis d'une autre zone du modèle de composants, et
cette zone du modèle de composants est décrite par une mise en réseau plus grossière d'éléments finis.
